# EUROPEAN PATENT SPECIFICATION

(11) **EP 1 480 277 B1**
(45) Date of publication and mention of the grant of the patent: **30.09.2015**
(21) Application number: 02806885.6
(22) Date of filing: 08.11.2002
(51) Int. Cl.: H01L 31/042

(54) **SOLAR CELL MODULE AND MANUFACTURING METHOD THEREOF**
SOLARZELLENMODUL UND HERSTELLUNGSVERFAHREN DAFÜR
MODULE SOLAIRE ET SON PROCEDE DE FABRICATION

(30) Priority: 28.02.2002 JP 2002053882
(43) Date of publication of application: 24.11.2004
(73) Proprietor: Shin-Etsu Chemical Co., Ltd., Tokyo 100-0004 (JP)
(72) Inventor: ABE, Takao, SHIN-ETSU HANDOTAI CO., LTD., Annaka-shi, Gunma 379-0196 (JP); OHTSUKA, Hiroyuki, SHIN-ETSU HANDOTAI CO., LTD., Annaka-shi, Gunma 379-0196 (JP)
(74) Representative: Oxley, Robin John George
(86) International application number: PCT/JP2002/011648
(87) International publication number: WO 2003/073516

(56) References cited:
- JP-A- 9 148 601
- JP-A- 11 298 023
- JP-A- 2001 094 127
- JP-A- 2002 076 413
- US-A- 4 089 705
- US-A- 4 313 023

## Description

### BACKGROUND OF THE INVENTION

### [Field of the Invention]

This invention relates to a solar battery module configured by arranging a plurality of solar battery cells produced using semiconductor single crystal substrates, and a method of fabricating the same.

### [Description of the Related Art]

Solar battery cells using semiconductor single crystal wafers are the mainstream of the solar battery currently disseminated, because they have a higher energy conversion efficiency as compared with that of cells using polycrystal or amorphous wafers, and also because the semiconductor single crystal wafers are relatively inexpensive.

The single crystal wafers, typically obtained by slicing a semiconductor single crystal manufactured by Czochralski method (simply referred to as the CZ method, hereinafter) or by the floating zone method (simply referred to as the FZ method, hereinafter), generally have a disk form. Assuming now that a ratio of area occupied by the solar battery cells to the total module area as module-packing ratio, a high level of module-packing ratio cannot be achieved simply by two-dimensionally arranging the disk-formed solar cells while keeping their wafer form, or in their intact disk form.

In order to improve a substantial energy conversion efficiency on the basis of the module area, it is necessary to raise the module-packing ratio. One general and well-known method of increasing the module-packing ratio is such as processing the solar cell batteries into a square form. The method is, however, disadvantageous in that cutting of a disk-formed semiconductor single crystal wafer so as to obtain a square-formed cell results in crystal loss.

To solve these problems in the module-packing ratio and crystal loss, a proposal has been made on producing hexagonal solar battery cells (see U. S. Patent No. 4,089,705). This method might reduce the crystal loss as compared with the aforementioned case of square-formed cells, but still cannot exempt from causing the crystal loss, and further raises problems in that the hexagonal processing is labor-consuming, and that the hexagonal shape prevents automated apparatuses generally used for LSI device process from being directly adopted.

U. S. Patent No. 4,313,023 and Japanese publication number JP 11298023 disclose solar cell modules in which a plurality of solar cells of the same shape are linearly arranged.

It is therefore an object of this invention to provide solar cell modules and a method of fabricating the same, capable of avoiding loss of single crystal wafer to be used, adopting apparatuses generally used for LSI device process, and raising the module-packing ratio as compared with the case where disk-formed cells are arranged without modification.

### DISCLOSURE OF THE INVENTION

As a solution to the aforementioned subject, a method of fabricating solar battery modules comprises the steps of divisionally producing two or more types of segments differing in shape from each other from each of disk-formed solar battery substrates, respectively collecting the same types of the segments, and two-dimensionally arranging the segments, by types, to thereby obtain respective solar battery modules, wherein the segments are produced by subjecting semiconductor single crystal wafers, as the solar battery substrates, in the disk form state thereof to cell formation process for forming solar battery cells respectively in the areas planned to be included later in the segments, and by dividing the wafers after completion of the cell formation process, and wherein the method of fabricating solar battery modules further comprising the steps of setting, as planned cutting lines, only one pair of parallel lines (referred to as parallel planned cutting lines, hereinafter) symmetrically arranged with respect to the center of the wafer on a main surface of the semiconductor single crystal wafers; subjecting the semiconductor single crystal wafers to the cell formation process respectively for a first segment forming area including the center of the wafer and for bow-formed second segment forming areas, which are the residual area besides the first segment forming area, to thereby form the solar battery cells; and cutting the solar battery cell along the planned cutting lines in the thickness-wise direction thereof, wherein the only one pair of the parallel planned cutting lines are set on the first main surface of the semiconductor single crystal wafer, wherein the segments having a shape remained after cutting the disk-formed solar battery cell along the only one pair of parallel planned cutting lines symmetrically set with respect to the center(O) of the main surface of the solar battery cell, so as to remove only one pair of bow-formed segments from the outer periphery portions are arranged in a parallel and staggered manner so that the parallel cut edges thereof are adjacent to each other.

More specifically, all portions of each solar battery substrate can divisionally be produced so as to make them belong to any one of the types of the segments. In other words, the semiconductor single crystal wafers before the cell formation process can completely be consumed up without causing residual portion, and do not cause crystal loss (excluding a portion consumed as a cutting width during segmentation using a cutting blade or the like).

Any processing for forming the solar battery cells (cell formation process) may of course be carried out after the semiconductor single crystal wafers are divided, but is more preferably targeted at semiconductor single crystal before being divided.

However, according to the invention the cell formation process is carried out respectively in the areas planned to be included later in the segments, and the wafers are divided after completion of the cell formation process. This process needs a separate pattern for cell formation for every planned area to be divided, but the cell formation process *per se* can be proceeded over the entire area of the wafer at a time, so that the solar battery modules can be fabricated by applying apparatuses similar to the conventional ones without any modification. In this case, the semiconductor single crystal wafers to be subjected to the cell formation process are preferably such as those being chamfered on the outer circumference thereof, similarly to wafers used for LSI device process. This makes it possible to reduce fraction defective such as cracking, chipping and so forth in the cell formation process, as compared typically with conventional square wafers subjected to the cell formation process without being chamfered.

According to the invention, the method of obtaining the segments divisionally produced from the disk-formed solar battery substrate comprises setting, as planned cutting lines, only one pair of parallel lines (referred to as parallel planned cutting lines, hereinafter) symmetrically arranged with respect to the center of the wafer on a main surface of the semiconductor single crystal wafers; subjecting the semiconductor single crystal wafers to the cell formation process respectively for a first segment forming area including the center of the wafer and for bow-formed second segment forming areas, which are the residual area besides the first segment forming area, to thereby form the solar battery cells; and cutting the solar battery cell along the planned cutting lines in the thickness-wise direction thereof. The first segments, which are major segments having a larger area, are of course used for fabrication of the solar battery module, but a most essential feature of this invention resides in that also the second segments, which have been understood merely as a fragment having a smaller area, and have simply been thought as being of no use other than being discarded (or rather, they are intrinsically of no interest after the first segments are picked up). Cutting of the wafer at parallel cutting positions spaced by a predetermined distance is advantageous also in that there is no need of using any special apparatuses and programs, and in that any automated apparatuses used for the conventional device process can be adopted without modification.

When the solar battery cell is divided into the first segment and second segment, too small area of the second segment results in an extremely large number of segments for composing a single solar battery module, and consequently in an increased number of process steps and costs. It is therefore preferable to limit the size of the second segment to an appropriate range relative to the size of the disk-formed solar battery cell to be used, which is typically from 10 to 30% of the size of the first segment.

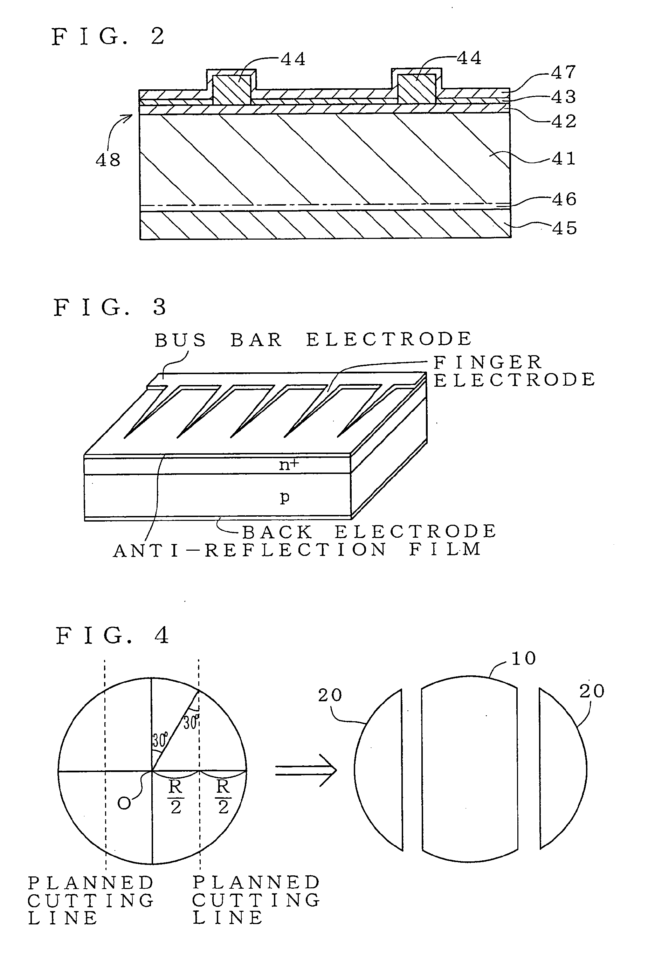

In view of reducing the number of process steps, only one pair of parallel planned cutting lines is set on the first main surface of the semiconductor single crystal wafer. In this case, it is convenient, as shown in FIG. 4, to determine the distance between each of the parallel planned cutting lines and the center of the wafer as R/2, where R is the radius of the disk-formed first main surface, because this makes it possible to make the total area of two second segments closer to the area of the first segment, to handle the second segments to be connected in parallel as one pair having various cell constants equivalent to those of the first segment, and to handle the first segment and second segment on a common design basis.

Using the first segments obtained by the aforementioned fabrication method, the solar battery module of this invention is as set out in Claim 9 and can be realized as follows. More specifically, the solar battery module is configured as having solar battery segments arranged in a parallel and staggered manner, each of the segments having a shape remained after cutting the disk-formed solar battery cell along only one pair of parallel planned cutting lines symmetrically set with respect to the center of the main surface of the solar battery cell, so as to remove only one pair of bow-formed segments from the outer periphery portions, and the segments being arranged so that the parallel cut edges thereof are adjacent to each other.

In the solar battery module of the invention, the first segment to be used has the parallel cut edges, and the arrangement in which the edges are adjacent to each other makes it possible to arrange the adjacent first segments over a relatively long distance. This is successful in achieving a far more larger module-packing ratio as compared with the case where the disk-formed solar battery cells are arranged in their intact form. This embodiment is also advantageous in that the cutting process, which is to produce only a single pair of the parallel cut edges, is simpler than that for the case where hexagonal or square segments must be produced.

In pursuit of an ideal module-packing ratio, the first segments are still causative of loss of module-packing ratio due to a pair of arc-formed circumferential portions remained in their shape. In view of optimizing the module-packing ratio, the first segments are arranged so that the arc-formed circumferential portions thereof are staggered, whereas the arrangement of the segments of an identical shape on a rectangular or square module panel raises another problem of periodically causing a large dead space in the segment arrangement along the panel edge.

It is now obvious that the cutting of the disk-formed solar battery cell along the aforementioned parallel planned cutting lines produces two bow-formed congruent second segments on both sides of the first segment. A solar battery module may be fabricated having a plurality of segment pairs arranged in a staggered manner, each of the segment pairs being composed of bow-formed segments having a planar form congruent with each other and being opposed on the chord-like edges thereof, and in a manner so that the chord-like edges are in parallel to each other.

Such a solar battery module can be fabricated by using portions of the single crystal substrate not used in the aforementioned first mode of embodiment, that is, by using the second segments. In other words, the second segments obtained by cutting the solar battery cells are paired so as to oppose both cut edges, and a plurality of thus-obtained segment pairs are arranged in a staggered manner.

In either configuration described in the above, the arc-formed second segments are equivalent to each other both in the area and shape, and therefore can function as solar batteries having an almost equal internal resistance. This makes it possible to readily match the output current among the solar batteries to be connected in series for the module making, and therefore to fabricate the solar battery modules having a desirable efficiency. Formation of the first segments in square is advantageous also in that the equivalent bow-formed second segments are produced in two pairs at a time.

If the module composed only of the first segments and the module composed only of the second segments are used in combination for solar power generation, it is possible to improve an average module-packing ratio as compared with that of the module having only the disk-formed solar battery cells having an equal area arranged therein based on the closest packing. This results in an effect substantially equivalent to that the energy conversion efficiency of the element is improved. Assuming now that only one pair of parallel planned cutting lines are set, and that the distance between each of the parallel planned cutting lines and the center of the wafer is set to R/2, calculation of an average of module-packing ratios of the above-described module of the first embodiment and the module of the second embodiment obtained from a single type of disk-formed cells reveals that the module-packing ratio is improved by approximately 4 to 5% as compared with that of the module having the disk-formed cells of an identical area arranged therein based on the closest packing (this will be detailed later).

In this invention, the cutting of the semiconductor single crystal wafer for producing the segments is preferably carried out using a dicer (diamond blade or laser cutting) which is generally used in LSI fabrication process. In the conventional solar battery formation process, a square cell, for example, has been sliced using a peripheral cutting edge, but this has resulted in only an insufficient accuracy in the cutting (±0.5 mm or around), and has failed in obtaining a module having a dense cell arrangement. On the contrary, use of the dicer capable of ensuring an accuracy of cutting of several micrometers to several tens micrometers makes it possible not only to fabricate a module having a dense cell arrangement with a cell gap of 1 mm or below, or further 500 µm or below, but also to facilitate automated arrangement operation of the cells.

### BRIEF DESCRIPTION OF THE DRAWINGS

FIG. 1 is a flow sheet showing exemplary process steps of fabricating the solar battery module of this invention;
FIG. 2 is a schematic view showing an exemplary sectional structure of a silicon-single-crystal-base solar battery;
FIG. 3 is a perspective view showing an exemplary mode of electrode formation on the light-receiving surface of the silicon-single-crystal-base solar battery;
FIG. 4 is a schematic drawing for explaining a method of cutting the first segment and the second segments from a single silicon single crystal wafer;
FIG. 5A is a schematic plan view showing an essential portion of a solar battery module fabricated by arranging only the first segments;
FIG. 5B is an overall view of the module shown in FIG. 5A;
FIG. 6A is a drawing for explaining dimension of the second segments;
FIG. 6B is a schematic plan view showing a solar battery module fabricated by arranging only the second segments;
FIG. 7 is a conceptual drawing of a texture structure;
FIG. 8 is a drawing schematically showing a sectional structure of a solar battery segment having the OECO structure;

### BEST MODES FOR CARRYING OUT THE INVENTION

The following paragraphs will describe best modes for carrying out this invention making reference to the attached drawings.

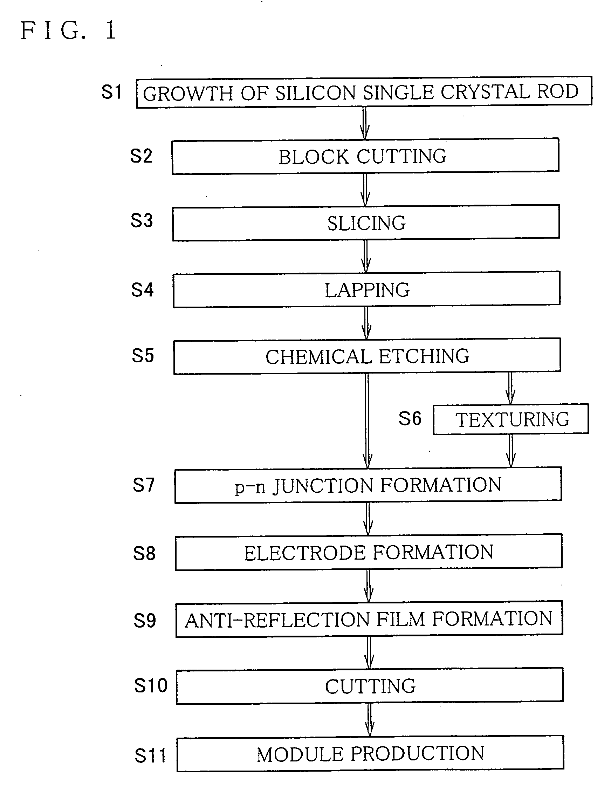

FIG. 1 is a flow sheet showing exemplary process steps of fabricating the solar battery modules of this invention. The process steps of fabricating the solar battery modules is roughly classified into a step of fabricating single crystal wafers which serve as the substrates, and a step of fabricating the solar battery cells (segments).

The step of fabricating single crystal wafers which serve as the substrates will be briefed below. The semiconductor single crystal wafer for producing solar batteries are generally silicon single crystal wafers. The silicon single crystal wafers can be obtained by slicing a single crystal rod obtained by the CZ method or FZ method. First, the silicon single crystal rod herein is fabricated by the CZ method (FIG. 1: S1). The silicon single crystal rod grown herein is added with gallium or boron, for example, to thereby adjust the conductivity type thereof to p type.

Thus-obtained single crystal ingot is then cut into blocks having a predetermined range of resistivity (FIG. 1: S2), and further sliced to a thickness of as thin as 300 µm for example (FIG. 1: S3). Each of the silicon single crystal wafers (simply referred to as wafer, hereinafter) obtained after the slicing is chamfered if necessary, and then lapped using free abrasive grains (FIG. 1: S4). The wafer is then dipped in an etching solution so as to chemically etch both main surfaces (FIG. 1: S5). The chemical etching step is provided in order to remove any damaged layers produced in the surficial portion of the silicon single crystal wafers during the mechanical process steps from S2 to S4. The removal of the damaged layers by the chemical etching is carried out by an acid etching using an aqueous mixed acid solution typically containing hydrofluoric acid, nitric acid and acetic acid. It is to be noted that the lapping in step S4 is often omitted for the wafers fabricated as the substrates for forming the solar battery cells, and that the etching process in step S5 and texturing process in step S6 may sometimes be combined.

To the silicon single crystal wafer undergone all processes up to the chemical etching (FIG. 1: S5), an n-type dopant diffused layer 42 is formed on the first main surface side to thereby form a p-n junction portion 48 as shown in FIG. 2 (FIG. 1: S7). The depth of the p-n junction portion 48 from the main surface of the wafer 41 is generally adjusted to 0.5 µm or around. The n-type dopant diffused layer 42 is formed by allowing phosphorus (P), for example, to disperse from the main surface of the p-type silicon single crystal wafer.

On the wafer 41 having the p-n junction portion 48 formed thereon, an oxide film 43 is formed on the first main surface thereof, an electrodes 44 and 45 are formed on the first main surface and second main surface, respectively, and thereby a disk-formed solar battery cell is produced (FIG. 1: S8). Because the solar battery cell is later cut into solar battery segments differing in the shape, so that it is necessary to form the electrode on the first main surface considering the shape of the segments obtained after the cutting. One possible method is such as setting a pair of parallel linear planned cutting lines (see FIG. 4) on the first main surface symmetrically with respect to the center point O of the wafer 41, so as to discriminate the first segment region containing the center point O and the adjacent bow-formed second segment regions on both sides of the first segment region bounded by the planned cutting lines, and carrying out the cell formation process respectively for these segment regions.

After the formation of the electrodes, an anti-reflecting film 47 for reducing light energy loss due to reflection of light is formed on the first main surface side (FIG. 1: S9), and thereby a solar battery cell is produced while keeping the shape of the disk-formed silicon single crystal wafer.

The electrode on the first main surface (light receiving surface) side shown in FIG. 2 typically has a form of finger electrode as shown in FIG. 3, which additionally has wide bus bar electrodes for reducing the internal resistance, provided at appropriate intervals. In contrast to this, the electrode 45 on the second main surface is formed so as to cover the nearly entire surface (FIG. 3; back electrode). On the other hand, the anti-reflection film 47 is composed of a transparent material having a refractive index different from that of silicon.

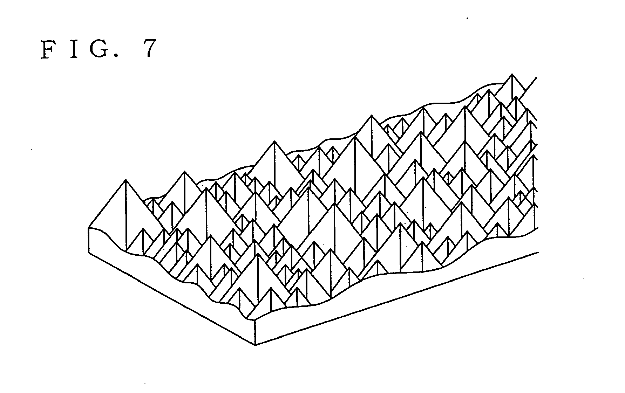

Any flat light-receiving surface may be more or less causative of reflection of light even covered with the anti-reflection film 47, but the reflection can further be suppressed by forming, after the chemical etching step, a texture structure composed of a large number of pyramid-formed projections exposing (111) surface on the first main surface as shown in FIG. 7 (FIG. 1: S6). This type of texture structure can be obtained by anisotropically etching the (100) surface of silicon single crystal using an etching solution such as an aqueous hydrazine solution or sodium hydroxide solution. For the case where the thinning of the substrate is desired to reduce the cell weight, it is allowable, as shown in FIG. 2, to form a back high concentration layer 46 having the same conductivity type with the substrate 41 but a higher concentration, on the second main surface side for the purpose of avoiding recombination and annihilation of minority carriers in the electrode 45 on the second main surface side.

The solar battery cell thus obtained has a disk form keeping the original shape of the wafer 41. This is cut using the dicer along the planned cutting lines in the thickness-wise direction with a desirable accuracy, to thereby divide it into the first segment 10 and two pieces of second segments 20, 20, differing in shape and having the electrodes preliminarily formed thereon according to the predetermined regions, as shown in FIG. 4 (FIG. 1: S10). Assuming that the wafer 41 obtained from a CZ silicon single crystal of 200 mm in diameter is adopted in this invention, the first segment 10 containing the center point O has an area of *ca*. 191.3 cm², and each of the second segments 20, 20 having no center point O has an area of *ca*. 61.37 cm². It is also allowable to first cut the wafer 41 into desired shapes and resultant pieces of the wafer 41 are subjected to the cell formation process.

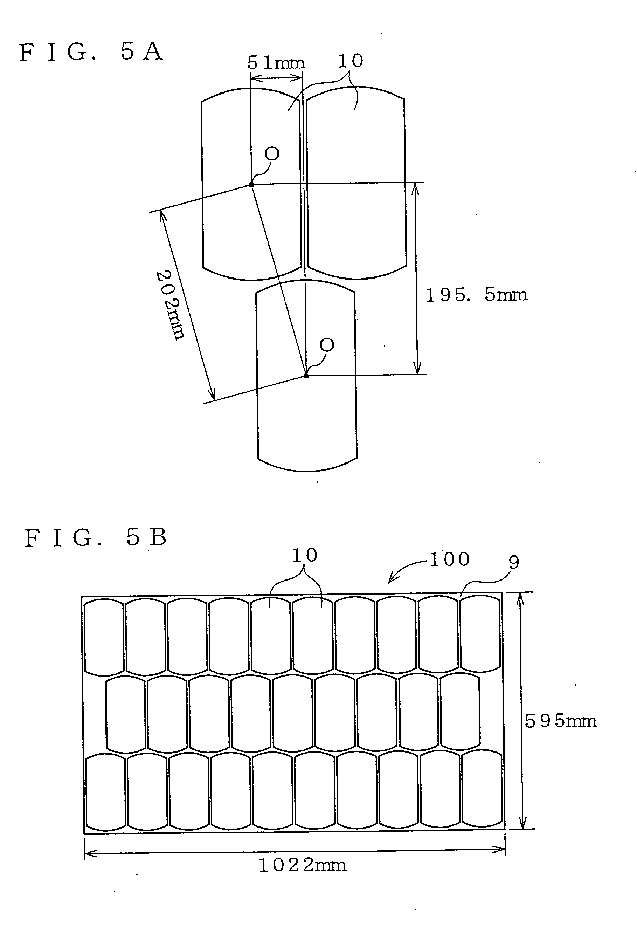

Next, only the first segments 10 are collected and arranged so as to maximize the module-packing ratio. FIG. 5B shows an exemplary arrangement of 29 first segments 10 obtained from 29 slices of 200-mm-diamter silicon single crystal wafers. The module 100 is configured as having the first segments 10 arranged therein in a parallel and staggered manner, so as to neighbor the parallel cut edges thereof (chord-like edge) with each other.

The solar battery module 100 has a rectangular shape which measures 595 mmx1022 mm. As illustrated in FIG. 5A, a gap between every adjacent cells, and a minimum distance between the cell and an edge of a frame on which the cells are placed are equally set to 2 mm. Assuming now that (module-packing ratio)=(occupied area of solar battery cells)/(occupied area of module), the module-packing ratio of the solar battery module 100 is calculated as approximately 91.2%.

The module-packing ratio can further be increased by reducing the cell gap to as narrow as 1 mm, for example.

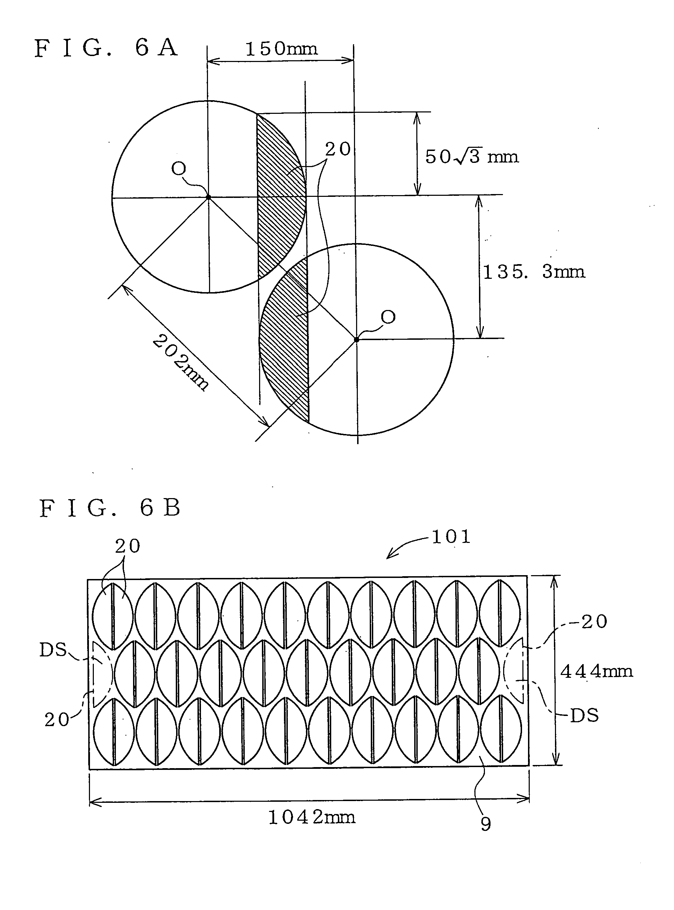

On the other hand, the bow-formed second segments 20, 20 are paired so as to oppose both cut edges, and a plurality of thus-obtained pairs are arranged so as to maximize the module-packing ratio as possible. FIG. 6B shows an exemplary arrangement of 29 pairs of second segments 20, 20 obtained from 29 slices of 200-mm-diamter silicon single crystal wafers 41 similarly to the case of the solar battery module 100 shown in FIG. 5B. The module 101 is configured as having pairs of the second segments 20, 20 arranged therein in a parallel and staggered manner.

The solar battery module 101 has a rectangular shape which measures 444 mm×1042 mm. Similarly to the foregoing case, a gap between every adjacent cells, and a minimum distance between the cell and an edge of a rectangular (or square) module plate (frame) 9 on which the cells are placed are equally set to 2 mm (FIG. 6A). The module-packing ratio of the solar battery module 101 is calculated as approximately 77.2%. It is to be noted that the staggered arrangement can be affected by a shift between the arrays of the second segments 20, 20, and tends to cause a relatively large dead space DS in every two arrays along the edge of the plate 9 at the end positions in the direction of shifting. The situation is the same also in the module 100 shown in FIG. 5B in which the first segments 10 are arranged in a staggered manner. The module 101 shown in FIG. 6B is, however, more advantageous because a unit of the staggered arrangement is composed of two second segments 20, 20, and this allows only one second segment 20 to fill the dead space DS as indicated by the dashed line. This is successful in further raising the module-packing ratio to as large as 79.8%.

The total module-packing ratio of the first and second solar battery modules configured as shown in FIG. 5B and FIG. 6B, respectively, is calculated as approximately 85.2 % (86.2% under filling of the dead space DS). In contrast to this, arrangement of 29 slices of disk-formed solar battery cells, kept in a disk form without division, in three arrays similarly to as shown in FIG. 5B and FIG. 6B results in a 553 mm×2022 mm module having a larger aspect ratio, which gives a module-packing ratio of approximately 81.4% (not illustrated). That is, the modules shown in FIG. 5B and FIG. 6B according to this invention are superior in the module-packing ratio by nearly 4% (5% under filling of the dead space DS) on the total basis.

Combination of the modules shown in FIG. 5B and FIG. 6B is also advantageous on the practical basis because a module having a nearly-square shape can be configured. Any similar nearly-square module configured by using 29 slices of the disk-formed solar battery will further lower the module-packing ratio. This invention is therefore successful in increasing the degree of freedom of selecting module shapes while keeping a high level of module-packing ratio.

In contrast to this, if 29 slices of the disk-formed solar battery cells are divided into two modules respectively comprising 14 slices (three-row, 5-4-5-slice arrangement) and 15 slices (three-row, 5-5-5-slice arrangement), the former results in a 553 mm×1012 mm module and the latter results in a 553 mm×1113 mm module, showing the module shapes equivalent to those in this invention, but results in module-packing ratios of approximately 78.6% and approximately 76.6%, giving a total module-packing ratio of two modules of 77.5%. It is obvious that the modules shown in FIG. 5B and FIG. 6B, which are the embodiments of this invention, can give the total module-packing ratio larger by as much as 7.5%.

a gap between the plate edge and the first segment, and a gap between the adjacent first segments set equally to 2 mm results in the module-packing ratio of as large as 97% or around. On the other hand, the second segments 22 can be configured as a solar battery cell module as shown in FIG. 10, which follows an arrangement similarly to as shown in FIG. 6 (dead spaces occurring along the plate edge are filled with the unpaired second segments 22). The module has the module-packing ratio of approximately 80%. The average module-packing ratio of the both is thus given as approximately 89%, which is improved by 7.6% from that (approximately 81.4%) of the module having the disk-formed solar battery cells arranged therein.

Because the cell gap can be narrowed to as small as 1 mm or below also in the cases shown in FIG. 9 and FIG. 10, it is possible to further increase the module-packing ratio.

This patent specification conceptually include also a shape of a first segment 21' shown in FIG. 11 such that the four corners slightly run out from the circumference of the circle, besides the inscribed square having a diagonal length almost equivalent to the diameter D of the disk-formed solar battery cell. Portions of four run-out corners have no entity as the solar battery cell, so that the actual shape of the first segment 21' will be a quasi-square lacking the four corners. Also this sort of quasi-square is handled as belonging to the concept of "square" if the diagonal length D' of the virtual square complemented by four corners falls within a range from 0.98 to 1.1 times of the diameter D (The lower limit may be smaller than 1. This will readily be understood considering reduction in size due to cutting width). FIG. 12 shows an exemplary configuration of the solar battery module using thus-obtained first segments 21'. Dead spaces 23 occur at every position where the apexes of the segments 21' face to each other due to the lack of four corners thereof. The module-packing ratio is therefore reduced to a slight degree, but is causative of only a negligible effect. FIG. 13 shows an exemplary configuration of the solar battery module using second segments 22'. It is obvious that narrowing of the width of the second segments 22' resulted in a larger number of arranged segments as compared with that in the module shown in FIG. 10.

FIG. 19 shows another exemplary configuration of the solar battery module gathering the bow-formed second segments 22. The configuration has a first-type segment array 30 in which a plurality of second segments 22 are unidirectionally arranged so that the chord portion (cut edge) 22g of one second segment 22 is neighbored on the arc portion 22k of the next second segment 22, and a second-type segment array 40 in which a plurality of second segments 22 are arranged so that the direction of the arrangement of the chord portion 22g and arc portion 22k is inverted from that in the first-type segment array 30. The first-type segment array 30 and the second-type segment array 40 are alternately arranged so that the end portions in the chord-wise direction of every second segment 22 in the second-type

For the case where the first segments and second segments obtained by cutting the disk-formed solar battery cells are used, a large dimensional variation in the cut segments consequently needs a larger gap between the adjacent segments in order to absorb the variation, and this inevitably lowers the module-packing ratio by the cells of the solar battery module. Use of a dicer having a disk-formed cutting edge such as that generally used in LSI fabrication process makes it possible to improve, to a considerable degree, the dimensional accuracy of the resultant first segments and second segments. This consequently makes it possible to bring the adjacent segment more closer, contributing improvement in the module-packing ratio by the cells.

Although the aforementioned embodiments exemplified the cases where the segments of the solar battery have the finger electrode formed thereon, it is also allowable to use other types of the solar battery. For example, each segment of the solar battery shown in FIG. 14 is configured so as to have a plurality of grooves 102 nearly in parallel to each other formed on the first main surface 124a thereof, wherein each of the grooves has an electrode 106 for output extraction on the inner surface thereof on one side in the width-wise direction. This sort of structure is referred to as OECO (obliquely evaporated contact) structure. Use of the inner surface of the grooves is successful in reducing a projection area of the electrode 106 onto the main surface, thereby the shadowing loss of the battery can considerably be reduced, and a large energy conversion efficiency can be achieved.

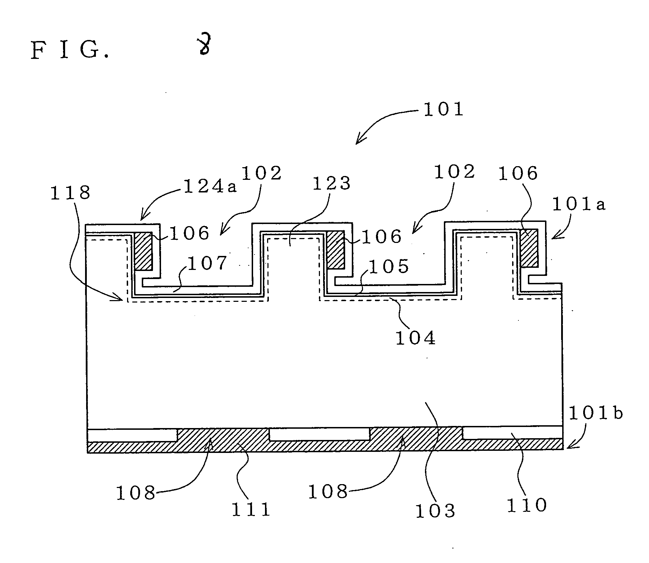

In the configuration shown in FIG. 8, on the first main surface 124a of the p-type silicon single crystal, a large number of grooves 102 typically having a width of 100 µm or around and a depth of 100 µm or around are formed in parallel to each other. The first main surface 124a having the grooves formed thereon, has an emitter layer 104 formed therein by thermally diffusing an n-type dopant so as to form a p-n junction portion. On the p-n junction, a thin silicon oxide film 105 which serves as a tunnel insulating film is formed typically by the thermal oxidation process.

On the silicon oxide film 105, the electrode 106 is formed. The electrode 106 is formed by obliquely evaporating an electrode material (metal such as aluminum, for example) onto the inner surface of the grooves in an evaporation apparatus. In the evaporation process, the substrate 101 is placed as being inclined by a predetermined angle or above relative to an evaporation source, so that only one side of the inner surface of the grooves as viewed in the width-wise direction is predominantly deposited with the electrode material (this is a reason of the naming of OECO: any unnecessary deposition of the electrode material possibly deposited on the top surface of convex ridges formed between every adjacent grooves 102, 102 will be removed later using an etching solution such as hydrochloric acid solution). The entire surface of the first main surface 124a of the substrate 101 including the electrode 106 is then covered with a silicon nitride film 107 which functions both as a protective film and anti-reflection film.

The segment having the OECO structure maximizes the conversion efficiency when the sunlight comes at an optimum angle to the direction of formation of the grooves. Orientation of the grooves differing from segment to segment in one module results in non-uniform output, and a considerable reduction in the power generation efficiency. It is therefore preferable to arrange the segments so that the orientation of the grooves coincide with each other.

As is obvious from the above, this invention can eliminate loss of single crystal wafer to be used, and can contribute to improvement in the module-packing ratio of the solar battery. It is to be understood that this invention is by no means limited to the aforementioned embodiments.

## Claims

1. A method of fabricating solar battery modules (101, 102) comprising the steps of divisionally producing two types of segments (10, 20, 21, 22) differing in shape from each other from each of disk-formed solar battery substrates, respectively collecting the same types of the segments, and two- dimensionally arranging the segments, by types, to thereby obtain respective solar battery modules, wherein the segments are produced by subjecting semiconductor single crystal wafers, as the solar battery substrates, in the disk form state thereof to cell formation process for forming solar battery cells respectively in the areas planned to be included later in the segments, and by dividing the wafers after completion of the cell formation process, and wherein the method of fabricating solar battery modules further comprising the steps of:
setting, as planned cutting lines, only one pair pairs of parallel lines (referred to as parallel planned cutting lines, hereinafter) symmetrically arranged with respect to the center (O) of the wafer on a main surface of the semiconductor single crystal wafers;
subjecting the semiconductor single crystal wafers to the cell formation process respectively for first segment forming areas including the center of the wafer and for bow-formed second segment forming areas, which are the residual area besides the first segment forming area, to thereby form the solar battery cells; and
cutting the solar battery cell along the planned cutting lines in the thickness-wise direction thereof so as to obtain the first type of segments from the first segment forming areas and the second type of segments from the second segment forming areas,
arranging a plurality of the first type of segments in a parallel and staggered manner so that the parallel cut edges thereof are adjacent to each other to thereby obtain a solar battery module.

2. The method of fabricating solar battery modules as claimed in Claim 1,
wherein all portions of each solar battery substrate are divisionally produced so as to make them belong to any one of the types of the segments.

3. The method of fabricating solar battery modules as claimed in Claim 6 1 to 2
wherein the distance between each of the parallel planned cutting lines and the center of the wafer is set to R/2, assuming R as the radius of the disk-formed first main surface.

4. The method of fabricating solar battery modules as claimed in any one of Claims 1 to 3 wherein the second type of segments (20) obtained by cutting the solar battery cell are paired by opposing the cut edges thereof, and thus-obtained segment pairs are arranged in staggered and parallel manner.

5. The method of fabricating solar battery modules as claimed in any one of Claims 1 to 3 wherein the second type of segments (20) are unidirectionally arranged so that the cut edge of one second type of segment, composing a chord portion thereof, is neighbored on the arc portion of an adjacent second type of segment to thereby form a first type array, and second type of segments are arranged so that the direction of the arrangement of the chord portion and arc portion is inverted from that in the first type array to thereby form a second-type array, and the first type array and the second type array are alternately arranged so that the end portions in the chord-wise direction of each second type of segment in the second type array are housed in each recessed portion formed between the chord portion of one second type of segment and the arc portion of an adjacent second type of segment in the first type array.

6. The method of fabricating solar battery modules as claimed in any one of Claims 1 to 5,
wherein each of the segments has a plurality of grooves (102) in parallel to each other formed on the first main surface thereof (124a), each of the grooves having an electrode (106) for output extraction on the inner surface thereof on one side in the width-wise direction, and the segments are arranged so that the orientation of the grooves coincide with each other.

7. A solar battery module (100) configured as having solar battery segments (10) arranged in a parallel and staggered manner, each of the segments having a shape remained after cutting a disk-formed solar battery cell along only one pair of parallel planned cutting lines symmetrically set with respect to the center (O) of the main surface of the solar battery cell, so as to remove only one pair of bow-formed segments from the outer periphery portions, and the segments being arranged so that the parallel cut edges thereof are adjacent to each other.

8. The solar battery module as claimed in Claim 7,
wherein each of the segments has a plurality of grooves (102) in parallel to each other formed on the first main surface thereof (124a), each of the grooves having an electrode (106) for output extraction on the inner surface thereof on one side in the width-wise direction, and the segments are arranged so that the orientation of the grooves coincide with each other.

## Patentansprüche

1. Verfahren zur Herstellung von Solarbatteriemodulen (101, 102), die Schritte umfassend: geteiltes Produzieren zweier Typen von Segmenten (10, 20, 21, 22), die sich in der Form voneinander unterscheiden, aus jedem von scheibenförmigen Solarbatteriesubstraten, jeweiliges Sammeln der Segmente gleichen Typs und zweidimensionales Anordnen der Segmente nach Typen, um dadurch jeweilige Solarbatteriemodule zu erlangen, worin die Segmente produziert werden, indem Halbleiter-Einkristallwafer wie die Solarbatteriesubstrate in ihrem scheibenförmigen Zustand einem Zellenbildungsprozess zum Ausbilden von Solarbatteriezellen jeweils in denjenigen Bereichen, die später in die Segmente einzubeziehen geplant ist, unterzogen werden, und indem die Wafer nach dem Abschluss des Zellenbildungsprozesses geteilt werden, und worin das Verfahren zur Herstellung von Solarbatteriemodulen ferner die Schritte umfasst:
Setzen nur eines Paars von parallelen Linien (hierin nachstehend als parallele geplante Schneidlinien bezeichnet), die symmetrisch in Bezug auf das Zentrum (O) des Wafers angeordnet sind, als geplante Schneidlinien auf einer Hauptoberfläche der Halbleiter-Einkristallwafer;
dem Zellenbildungsprozess Unterziehen der Halbleiter-Einkristallwafer, und zwar jeweils für erste Segmentbildungsbereiche, die das Zentrum des Wafers einschließen, und für bogenförmige zweite Segmentbildungsbereiche, welche der Restbereich neben dem ersten Segmentbildungsbereich sind, um dadurch die Solarbatteriezellen zu bilden;
Schneiden der Solarbatteriezelle entlang der geplanten Schneidlinien in Richtung ihrer Dicke, um dadurch den ersten Typ von Segmenten aus den ersten Segmentbildungsbereichen und den zweiten Typ von Segmenten aus den zweiten Segmentbildungsbereichen zu erlangen; und
Anordnen einer Vielzahl von Segmenten des ersten Typs auf eine parallele und versetzte Weise, sodass ihre parallelen Schnittkanten einander benachbart sind, um dadurch ein Solarbatteriemodul zu erlangen.

2. Verfahren zur Herstellung von Solarbatteriemodulen nach Anspruch 1,
worin alle Abschnitte jedes Solarbatteriesubstrats geteilt produziert werden, um sie dadurch zu einem der Typen der Segmente zugehörig zu machen.

3. Verfahren zur Herstellung von Solarbatteriemodulen nach Anspruch 1 bis 2,
worin der Abstand zwischen jeder der parallelen geplanten Schneidlinien und dem Zentrum des Wafers auf R/2 eingestellt wird, wobei R als der Radius der scheibenförmigen ersten Hauptoberfläche angenommen wird.

4. Verfahren zur Herstellung von Solarbatteriemodulen nach einem der Ansprüche 1 bis 3,
worin die Segmente vom zweiten Typ (20), die durch Schneiden der Solarbatteriezelle erlangt werden, durch Gegenüberlegen ihrer Schnittkanten gepaart werden und so erlangte Segmentpaare auf parallele und versetzte Weise angeordnet werden.

5. Verfahren zur Herstellung von Solarbatteriemodulen nach einem der Ansprüche 1 bis 3,
worin die Segmente vom zweiten Typ (20) unidirektional angeordnet werden, sodass die Schnittkante eines Segments vom zweiten Typ, die seinen Sehnenabschnitt bildet, an den Bogenabschnitt eines benachbarten Segments vom zweiten Typ angrenzt, um dadurch eine Anordnung ersten Typs zu bilden, und Segmente vom zweiten Typ so angeordnet werden, dass die Richtung der Anordnung des Sehnenabschnitts und des Bogenabschnitts gegenüber jener in der Anordnung ersten Typs umgekehrt ist, um dadurch eine Anordnung zweiten Typs zu bilden, und die Anordnung ersten Typs und die Anordnung zweiten Typs abwechselnd angeordnet werden, sodass die Endabschnitte in Sehnenrichtung jedes Segments vom zweiten Typ in der Anordnung zweiten Typs in jedem ausgesparten Abschnitt aufgenommen werden, der zwischen dem Sehnenabschnitt eines Segments vom zweiten Typ und dem Bogenabschnitt eines benachbarten Segments vom zweiten Typ in der Anordnung ersten Typs ausgebildet ist.

6. Verfahren zur Herstellung von Solarbatteriemodulen nach einem der Ansprüche 1 bis 5,
worin jedes der Segmente eine Vielzahl von zueinander parallelen Rillen (102) aufweist, die auf seiner ersten Hauptoberfläche (124a) ausgebildet sind, wobei jede der Rillen auf ihrer Innenfläche auf einer Seite in Richtung der Breite eine Elektrode (106) zur Entnahme der Ausgangsleistung aufweist und die Segmente so angeordnet sind, dass die Orientierung der Rillen miteinander übereinstimmt.

7. Solarbatteriemodul (100), das so konfiguriert ist, dass es Solarbatteriesegmente (10) aufweist, die auf eine parallele und versetzte Weise angeordnet sind, wobei jedes der Segmente eine Form hat, die nach dem Schneiden einer scheibenförmigen Solarbatteriezelle entlang nur einem Paar von parallelen geplanten Schneidlinien, die symmetrisch in Bezug auf das Zentrum (O) der Hauptoberfläche der Solarbatteriezelle gesetzt sind, um dadurch nur ein Paar von bogenförmigen Segmenten von den äußeren Randabschnitten zu entfernen, übrig bleibt, und wobei die Segmente so angeordnet werden, dass ihre parallelen Schnittkanten aneinander benachbart sind.

8. Solarbatteriemodul nach Anspruch 7, worin jedes der Segmente eine Vielzahl von zueinander parallelen Rillen (102) aufweist, die auf seiner ersten Hauptoberfläche (124a) ausgebildet sind, wobei jede der Rillen auf ihrer Innenfläche auf einer Seite in Richtung der Breite eine Elektrode (106) zur Entnahme der Ausgangsleistung aufweist und die Segmente so angeordnet sind, dass die Orientierung der Rillen miteinander übereinstimmt.

## Revendications

1. Procédé de fabrication de modules de batterie solaire (101, 102) comprenant les étapes consistant à produire par division deux types de segments (10, 20, 21, 22) différant les uns des autres par leur forme à partir de chacun des substrats de batterie solaire en forme de disque, rassembler respectivement les mêmes types des segments, et agencer en deux dimensions les segments, par types, afin d'obtenir ainsi des modules de batterie solaire respectifs, dans lequel les segments sont produits en soumettant des tranches monocristallines semi-conductrices, faisant office de substrats de batterie solaire, sous forme de disque, à un procédé de formation de cellules permettant de former des cellules de batterie solaire respectivement dans les zones destinées à être incluses ultérieurement dans les segments, et en divisant les tranches après la fin du procédé de formation de cellules, et dans lequel le procédé de fabrication de modules de batterie solaire comprend en outre les étapes consistant à :
poser, en tant que lignes de découpe planifiées, seulement une paire de paires de lignes parallèles (appelées ci-dessous lignes de découpe planifiées parallèles) agencées symétriquement par rapport au centre (O) de la tranche sur une surface principale des tranches monocristallines semi-conductrices ;
soumettre les tranches monocristallines semi-conductrices au procédé de formation de cellules respectivement pour des premières zones de formation de segment incluant le centre de la tranche et pour des secondes zones de formation de segment en forme d'arc, qui représentent la zone résiduelle située en dehors de la première zone de formation de segment, afin de former ainsi les cellules de batterie solaire ; et
découper la cellule de batterie solaire le long des lignes de découpe planifiées dans la direction de l'épaisseur de celle-ci de manière à obtenir le premier type de segments à partir des premières zones de formation de segment et le second type de segments à partir des secondes zones de formation de segment ; et
agencer une pluralité de segments du premier type de manière parallèle et échelonnée de manière à ce que les bords de découpe parallèles de ceux-ci soient adjacents les uns aux autres afin d'obtenir ainsi un module de batterie solaire.

2. Procédé de fabrication de modules de batterie solaire selon la revendication 1,
dans lequel toutes les parties de chaque substrat de batterie solaire sont produites par division de manière à ce qu'elles appartiennent à un quelconque des types de segments.

3. Procédé de fabrication de modules de batterie solaire selon la revendication 1 à 2,
dans lequel la distance entre chacune des lignes de découpe planifiées parallèles et le centre de la tranche est définie comme étant R/2, où R est le rayon de la première surface principale en forme de disque.

4. Procédé de fabrication de modules de batterie solaire selon l'une quelconque des revendications 1 à 3,
dans lequel les segments (20) du second type obtenus par découpe de la cellule de batterie solaire sont appariés en mettant face à face les bords de découpe de ceux-ci, et les paires de segments ainsi obtenus sont agencées de manière parallèle et échelonnée.

5. Procédé de fabrication de modules de batterie solaire selon l'une quelconques des revendications 1 à 3,
dans lequel les segments (20) du second type sont agencés de manière unidirectionnelle de sorte que le bord de découpe d'un segment du second type, qui constitue une partie corde de celui-ci, est au voisinage de la partie arc d'un segment adjacent du second type afin de former ainsi un premier type de réseau, et des segments du second type sont agencés de sorte que la direction de l'agencement de la partie corde et de la partie arc est inversée par rapport à celle du premier type de réseau afin de former ainsi un second type de réseau, et le premier type de réseau et le second type de réseau sont agencés alternativement de sorte que les parties extrémité dans la direction de corde de chaque segment du second type dans le second type de réseau sont hébergées dans chaque partie renfoncée formée entre la partie corde d'un segment du second type et la partie arc d'un segment adjacent du second type dans le premier type de réseau.

6. Procédé de fabrication de modules de batterie solaire selon l'une quelconque des revendications 1 à 5,
dans lequel chacun des segments présente une pluralité de rainures (102) parallèles les unes aux autres et formées sur la première surface principale (124a) de ceux-ci, chacune des rainures présentant une électrode (106) pour une extraction de production sur la surface intérieure de celles-ci sur un côté dans la direction de la largeur, et les segments sont agencés de sorte que les orientations des rainures coïncident les unes avec les autres.

7. Module de batterie solaire (100) configuré de manière à présenter des segments (10) de batterie solaire agencés de manière parallèle et échelonnée, chacun des segments présentant une forme qui subsiste après découpe d'une cellule de batterie solaire en forme de disque le long de seulement une paire de lignes de découpe planifiées parallèles définies de manière symétrique par rapport au centre (O) de la surface principale de la cellule de batterie solaire, de manière à retirer seulement une paire de segments en forme d'arc à partir des parties périphériques extérieures, et les segments étant agencés de sorte que les bords de découpe parallèles de ceux-ci sont adjacents les uns aux autres.

8. Modules de batterie solaire selon la revendication 7, dans lequel chacun des segments présente une pluralité de rainures (102) parallèles les unes aux autres formées sur la première surface principale (124a) de ceux-ci, chacune des rainures présentant une électrode (106) pour une extraction de production sur la surface intérieure de celles-ci sur un côté dans la direction de la largeur, et les segments sont agencés de sorte que les orientations des rainures coïncident les unes avec les autres.
